# EUROPÄISCHE PATENTSCHRIFT

(11) **EP 0 408 778 B1**
(45) Veröffentlichungstag und Bekanntmachung des Hinweises auf die Patenterteilung: **13.04.1994**
(21) Anmeldenummer: 89113083.3
(22) Anmeldetag: 17.07.1989
(51) Int. Cl.: H03K 17/13, H03K 17/79

(54) **Nullpunktdetektor für einen optisch steuerbaren Thyristor**
Zero-crossing detector for an optically controlled thyristor
Detecteur de passage par zéro pour thyristor à commande optique

(43) Veröffentlichungstag der Anmeldung: 23.01.1991
(73) Patentinhaber: SIEMENS AKTIENGESELLSCHAFT, 80333 München (DE)
(72) Erfinder: Gantioler, Josef Matthias, Dipl.-Ing., D-8000 München 81 (DE); Tihanyi, Jenö, Dr., D-8000 München 70 (DE)

(56) Entgegenhaltungen:
- EP-A- 0 107 137
- EP-A- 0 144 978
- EP-A- 0 319 870
- US-A- 4 697 097

## Beschreibung

Die Erfindung bezieht sich auf eine Schaltungsanordnung mit einem Thyristor, mit einem Fototransistor, dessen Laststrom den Steuerstrom für den Thyristor liefert, mit einem MOSFET, der im leitenden Zustand den Basisstrom des Fototransistors ableitet, wenn die Anodenspannung des Thyristors (Thyristorspannung) einen vorgegebenen Wert übersteigt.

Eine solche Schaltungsanordnung ist als "Nullpunktdetektor" bekannt und wird z. B. in Festkörper-Relais eingesetzt. Eine Schaltungsanordnung eines Festkörper-Relais ist z. B. in der EP-O 144 978 Bl beschrieben worden. Der Nullpunktdetektor enthält einen zwischen den Basisanschluß des Fototransistors und einer auf festen Potential liegenden Klemme eingeschalteten MOSFET. Der Gateanschluß dieses MOSFET ist über eine bezüglich der Thyristorspannung in Sperrichtung gepolte Fotodiode mit einer weiteren Klemme verbunden, an der eine der Thyristorspannung folgende Spannung liegt. Übersteigt diese Spannung einen vorgegebenen Wert und wird die Fotodiode belichtet, so lädt ihr fotoelektrisch erhöhter Sperrstrom die Gate-Sourcekapazität des MOSFET auf und steuert diesen leitend. Damit wird der Fotostrom des Fototransistors abgeleitet und der Thyristor kann trotz Belichtung des Fototransistors nicht leitend gesteuert werden.

Die genannte Schaltungsanordnung hat sich hinsichtlich des Spannungsfensters in integrierter Form als nicht sicher reproduzierbar erwiesen.

Ziel der Erfindung ist es, eine Schaltungsanordnung der erwähnten Art so weiterzubilden, daß sie auch als integrierte Schaltung ein mit großer Genauigkeit reproduzierbares Spannungsfenster liefert, innerhalb dessen das Einschalten des Thyristors möglich ist und außerhalb dessen das Einschalten des Thyristors unterbunden wird.

Dieses Ziel wird durch die Merkmale der Ansprüche erreicht.

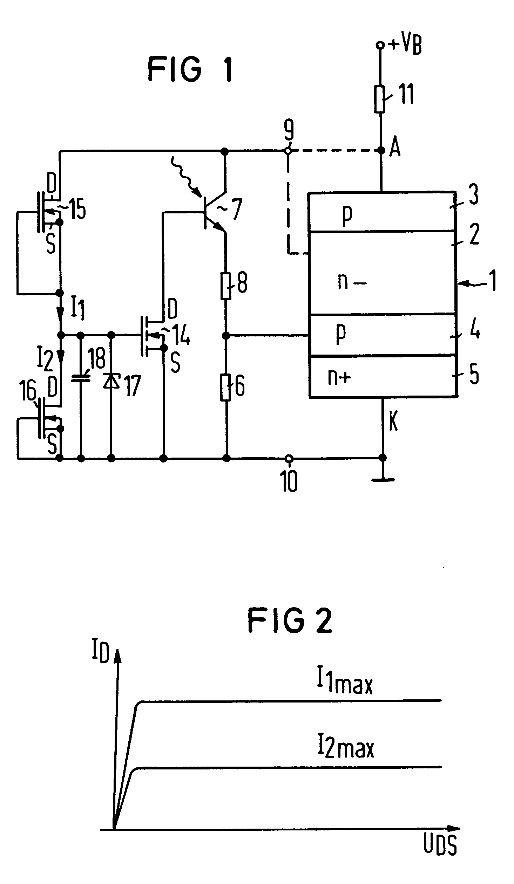

Die Erfindung wird anhand eines Ausführungsbeispiels in Verbindung mit den Figuren 1 und 2 näher erläutert. Dabei zeigen FIG 1 ein Schaltungsdiagramm und FIG 2 die Strom/Spannungskennlinien der Stromquellen.

Die Schaltungsanordnung nach FIG 1 enthält einen Thyristor 1 mit einer Innenzone 2, einer Anodenzone 3, einer katodenseitigen Basiszone 4 und einer Katodenzone 5. Die Dotierung ist von der Anode A zur Katode K z. B. pn⁻pn⁺. Der Thyristor ist anodenseitig über eine Last 11 mit einer Versorgungsspannung V_{B} verbunden, katodenseitig liegt er z. B. auf Massepotential.

Die Thyristorspannung liegt an zwei Anschlußklemmen 9 und 10, die mit der Anode A bzw. der Katode K verbunden sind. Mit der Anschlußklemme 9 ist der Kollektoranschluß eines Fototransistors 7 verbunden, dessen Emitteranschluß über einen Widerstand 8 mit der Basiszone des Thyristors 1 verbunden ist. Die Basiszone 4 und die Katodenzone 5 sind über einen Nebenschlußwiderstand 6 elektrisch miteinander verbunden. Dieser Widerstand ist im allgemeinen Bestandteil des Thyristors selbst. Der Basisanschluß des Fototransistors 7 ist über die Drain- Sourcestrecke eines Enhancement-MOSFET 14 mit der Anschlußklemme 10 verbunden. Zwischen dem Gateanschluß des MOSFET 14 und der Anschlußklemme 9 liegt eine Stromquelle 15, zwischen dem Gateanschluß und dem Sourceanschluß des MOSFET 14 ist eine Stromquelle 16 angeschlossen. Beide Stromquellen sind vorzugsweise Depletion-MOSFET, deren Gateanschlüsse jeweils mit den Sourceanschlüssen verbunden sind. Dabei ist der Sourceanschluß des die Stromquelle 15 bildenden MOSFET mit dem Drainanschluß der die Stromquelle 16 bildenden MOSFET verbunden. Der maximale Strom der Stromquelle 15 ist höher als der der Stromquelle 16. Zwischen dem Gateanschluß und dem Sourceanschluß des MOSFET 14 ist eine Zenerdiode 17 geschaltet. Der Zenerdiode 17 kann gemäß einer Weiterbildung ein Kondensator 18 parallel geschaltet sein.

Zur Erläuterung der Funktion wird davon ausgegangen, daß die Thyristorspannung vom Wert Null in positive Richtung ansteigt. Ist die Thyristorspannung, d. h. die Spannung an den Anschlußklemmen 9, 10 nur wenig von Null verschieden, so fließt ein geringer Strom von +V_{B} über die Last 11, durch die Stromquelle 15 und die Stromquelle 16 zur Anschlußklemme 10. Ist dieser Strom kleiner als derjenige Strom I₂, den die Stromquelle 16 maximal zuläßt, liegt am Gateanschluß des MOSFET 14 eine Spannung an, die nur wenig von Null verschieden und kleiner als die Einsatzspannung des MOSFET ist. Der MOSFET 14 ist damit gesperrt. Trifft nun Licht auf den Fototransistor 7, wird dieser eingeschaltet und sein Fotostrom kann den Thyristor 1 zünden.

Steigt die Thyristorspannung weiter an, so erhöht sich der Strom I₂ so lange, bis der maximale Strom I₂ₘₐₓ (FIG 2) von z. B. 1 µA erreicht ist. Damit steigt die Gate-Sourcespannung am MOSFET an, bis seine Einsatzspannung erreicht ist. Dann wird der MOSFET 14 leitend gesteuert und leitet den Kollektor-Basis-Sperrstrom des Fototransistors 7 nach Masse ab. Wird der Fototransistor 7 jetzt beleuchtet, so kann der Thyristor 1 nicht mehr leitend gesteuert werden.

Mit weiter ansteigender Thyristorspannung steigt der Strom I₁ durch die Stromquelle 15 weiter an und mit ihm die Gate-Sourcespannung des MOSFET 14. Wird die Zenerspannung der Zenerdiode 17 erreicht, so begrenzt diese die Gate-Sourcespannung des MOSFET 14 auf einen Wert, der ausreicht, um den MOSFET 14 vollkommen leitend zu steuern. Mit dem Durchbruch der Zenerdiode 17 erhöht sich der Strom I₁ auf den maximalen, durch die Stromquelle 15 fließenden Strom I₁ₘₐₓ (FIG 2), z. B. 2 µA und die Stromquelle 15 nimmt Spannung auf. Mit steigender Thyristorspannung erhöht sich die Spannung an der Stromquelle 15, während die an der Stromquelle 16 liegende Spannung konstant bleibt.

Da die Stromquelle 15 eine hohe Spannung von z. B. 800 Volt aufnehmen muß, ist sie als Vertikal-Depletion-MOSFET aufgebaut. Die Stromquelle 16 dagegen nimmt nur wenige Volt auf und kann z. B. als Lateral-Depletion-MOSFET ausgebildet sein.

Wird der Zenerdiode 17 der Kondensator 18 parallel geschaltet, so ist es möglich, anstelle des spannungsabhängigen Einschaltens des MOSFET 14 ein zeitabhängiges Einschalten zu erreichen. Dazu muß die Kapazität des Kondensators 18 größer als die Gate-Sourcekapazität des MOSFET 14 sein. Sie kann z. B. 10 mal größer als jene sein.

Wird die in FIG 1 gezeigte Schaltungsanordnung in integrierter Form aufgebaut, so ist es möglich, die Klemme 9 direkt mit der Innenzone 2 des Thyristors zu verbinden, wie durch die gestrichelte Verbindung angedeutet ist. Die Innenzone 2 des Thyristors wird hierbei in der Regel durch eine schwach n-dotierte Epitaxiezone der integrierten Schaltung gebildet, in die alle gezeigten Bauelemente planar eingebettet sind. In diesem Fall liegt an der Klemme 9 eine der Thyristorspannung folgende Spannung.

## Patentansprüche

1. Schaltungsanordnung mit einem Thyristor (1), mit einem Fototransistor (7), dessen Laststrom den Steuerstrom für den Thyristor liefert, mit einem MOSFET (14), der im leitenden Zustand den Basisstrom des Fototransistors ableitet, wenn die Anodenspannung des Thyristors einen vorgegebenen Wert übersteigt, mit den Merkmalen:
a) An einer Anschlußklemme (9) liegt die Anodenspannung des Thyristors (1),
b) zwischen Gate- und Sourceanschluß des MOSFET ist eine erste Stromquelle (16) angeschlossen,
c) zwischen Gateanschluß und Sourceanschluß des MOSFET (14) ist eine Zenerdiode (17) angeschlossen,
**gekennzeichnet durch** die Merkmale:
d) zwischen dem Gateanschluß des MOSFET 14 und der Anschlußklemme (9) ist eine zweite Stromquelle (15) angeschlossen,
e) der maximale Strom der zweiten Stromquelle (15) ist größer als der maximale Strom der ersten Stromquelle (16).

2. Schaltungsanordnung mit einem Thyristor (1), mit einem Fototransistors (7), dessen Laststrom den Steuerstrom für den Thyristor liefert, mit einem MOSFET (14), der im leitenden Zustand den Basisstrom des Fototransistors ableitet, wenn die Anodenspannung des Thyristors einen vorgegebenen Wert übersteigt, mit den Merkmalen:
a) Zwischen Gate- und Sourceanschluß des MOSFET ist eine erste Stromquelle (16) angeschlossen,
b) zwischen Gateanschluß und Sourceanschluß des MOSFET (14) ist eine Zenerdiode (17) angeschlossen,
**gekennzeichnet durch** die Merkmale:
c) zwischen den Gateanschluß des MOSFET (14) und einer Anschlußklemme (9) ist eine zweite Stromquelle (15) angeschlossen,
d) an der Anschlußklemme (9) liegt eine der Anodenspannung des Thyristors folgende Spannung,
e) der maximale Strom der zweiten Stromquelle (15) ist größer als der maximale Strom der ersten Stromquelle (16).

## Claims

1. Circuit arrangement having a thyristor (1), having a phototransistor (7) whose load current supplies the control current for the thyristor, having a MOSFET (14) which, in the conductive state, dissipates the base current of the phototransistor when the anode voltage of the thyristor exceeds a predetermined value, having the features:
a) the anode voltage of the thyristor (1) is applied to a connecting terminal (9),
b) a first power source (16) is connected between the gate connection and the source connection of the MOSFET,
c) a zener diode (17) is connected between the gate connection and the source connection of the MOSFET (14),
characterized by the features:
d) a second power source (15) is connected between the gate connection of the MOSFET (14) and the connecting terminal (9),
e) the maximum current from the second power source (15) is greater than the maximum current from the first power source (16).

2. Circuit arrangement having a thyristor (1), having a phototransistor (7) whose load current supplies the control current for the thyristor, having a MOSFET (14) which, in the conductive state, dissipates the base current of the phototransistor when the anode voltage of the thyristor exceeds a predetermined value, having the features:
a) a first power source (16) is connected between the gate connection and source connection of the MOSFET,
b) a zener diode (17) is connected between the gate connection and source connection of the MOSFET (14),
characterized by the features:
c) a second power source (15) is connected between the gate connection of the MOSFET (14) and a connecting terminal (9),
d) a voltage which follows the anode voltage of the thyristor is applied to the connecting terminal (9),
e) the maximum current from the second power source (15) is greater than the maximum current from the first power source (16).

## Revendications

1. Montage comportant un thyristor (1), un phototransistor (7), dont le courant de charge fournit le courant de commande pour le thyristor, un transistor MOSFET (14) qui, à l'état conducteur, évacue le courant de base du phototransistor lorsque la tension d'anode du thyristor dépasse une valeur prédéterminée, présentant les particularités suivantes :
a) la tension d'anode du thyristor (1) est appliquée à une borne de raccordement (9),
b) une première source de courant (16) est branchée entre la borne de grille et la borne de source du transistor MOSFET,
c) une diode Zener (17) est branchée entre la borne de grille et la borne de source du transistor MOSFET (14),
remarquable par les caractéristiques suivantes :
d) une seconde source de courant (15) est branchée entre la borne de grille du transistor MOSFET (14) et la borne de raccordement (9),
e) le courant maximum de la seconde source de courant (15) est supérieur au courant maximum de la première source de courant (16).

2. Montage comportant un thyristor (1), un phototransistor (7), dont le courant de charge fournit le courant de commande pour le thyristor, un transistor MOSFET (14) qui, à l'état conducteur, évacue le courant de base du phototransistor lorsque la tension d'anode du thyristor dépasse une valeur prédéterminée, présentant les particularités suivantes :
a) une première source de courant (16) est branchée entre la borne de grille et la borne de source du transistor MOSFET,
b) une diode Zener (17) est branchée entre la borne de grille et la borne de source du transistor MOSFET (14),
remarquable par les caractéristiques suivantes :
c) une seconde source (15) est branchée entre la borne de grille du transistor MOSFET (14) et une borne de raccordement (9),
d) une tension, qui est asservie à la tension d'anode du thyristor, est appliquée à la borne de raccordement (9),
e) le courant maximum de la seconde source de courant (15) est supérieur au courant maximum de la première source de courant (16).
